(19)

Europäisches
Patentamt
European
Patent Office
Office européen
des brevets

(11) **EP 2 701 144 B1**

(12) **EUROPEAN PATENT SPECIFICATION**

(45) Date of publication and mention
of the grant of the patent:
**27.07.2016 Bulletin 2016/30**

(51) Int Cl.:
*G10L 19/02* (2013.01)    *G10L 19/00* (2013.01)

(21) Application number: **12774449.8**

(86) International application number:
**PCT/JP2012/001701**

(22) Date of filing: **12.03.2012**

(87) International publication number:
**WO 2012/144127 (26.10.2012 Gazette 2012/43)**

(54) **DEVICE AND METHOD FOR EXECUTION OF HUFFMAN CODING**

VORRICHTUNG UND VERFAHREN ZUR AUSFÜHRUNG EINER HUFFMAN-CODIERUNG

DISPOSITIF ET PROCÉDÉ D'EXÉCUTION D'UN CODAGE DE HUFFMAN

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **20.04.2011 JP 2011094295
15.06.2011 JP 2011133432**

(43) Date of publication of application:
**26.02.2014 Bulletin 2014/09**

(60) Divisional application:
**16175414.8**

(73) Proprietor: **Panasonic Intellectual Property
Corporation
of America
Torrance, CA 90503 (US)**

(72) Inventors:
• **LIU, Zongxian
Singapore 534415 (SG)**

• **CHONG, Kok Seng
Singapore 534415 (SG)**
• **OSHIKIRI, Masahiro
Osaka 540-6207 (JP)**

(74) Representative: **Grünecker Patent- und
Rechtsanwälte
PartG mbB
Leopoldstraße 4
80802 München (DE)**

(56) References cited:
**WO-A1-2005/004113       JP-A- 7 261 800
JP-A- 2002 268 693       JP-A- 2002 268 693
JP-A- 2003 233 397       JP-A- 2004 246 224
JP-A- 2008 032 823       US-A1- 2006 074 693
US-B1- 7 668 715**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

Technical Field

The present invention relates to an audio/speech encoding apparatus, audio/speech decoding apparatus and audio/speech encoding and decoding methods using Huffman coding.

Background Art

In signal compression, Huffman coding is widely used to encode an input signal utilizing a variable-length (VL) code table (Huffman table). Huffman coding is more efficient than fixed-length (FL) coding for the input signal which has a statistical distribution that is not uniform.
In Huffman coding, the Huffman table is derived in a particular way based on the estimated probability of occurrence for each possible value of the input signal. During encoding, each input signal value is mapped to a particular variable length code in the Huffman table.
By encoding signal values that are statistically more likely to occur using relatively short VL codes (using relatively few bits), and conversely encoding signal values that are statistically infrequently to occur using relatively long VL codes (using relatively more bits), the total number of bits used to encode the input signal can be reduced.

Citation List

[Non-patent document 1] ITU-T Recommendation G.719 (06/2008) "Low-complexity, full-band audio coding for high-quality, conversational applications"
JP 2002 268693 A relates to quantizing a transformation coefficient (i.e. spectrum) in a sub band of an input signal and encoding it with Huffman code, and focuses on the quantization step. In particular, the rate/distortion control section 304 adjusts a scaling factor for quantization of the transformation coefficient. The rate/distortion control section 304 adjusts a scaling factor so as to reduce a quantization error of a sub band which has a large quantization error. Further, it discloses the case of determining a scaling factor with the relative difference between a quantization error and a masking threshold. It also discloses, in that case, the quantization value becomes large and, therefore, the bits consumption required to Huffman-encode is necessarily increased.
US 2006/074693 A1 relates to a quantizing step and discloses that scale factor sf[sb] is reduced such that the scale factor sf[sb] becomes below a masking power threshold.

Summary of Invention

Technical Problem

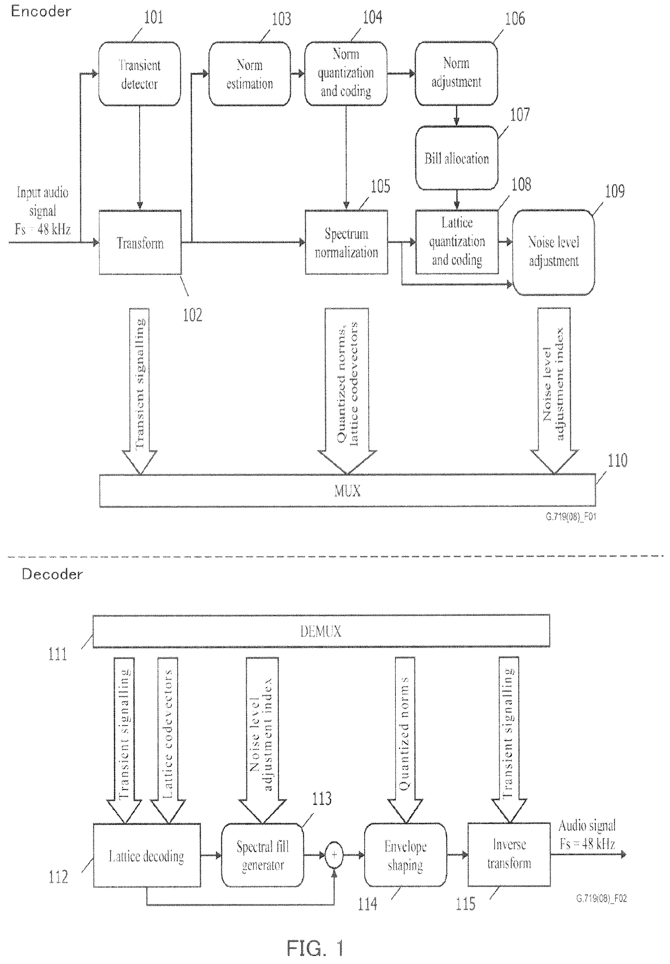

However, in some applications, such as audio signal encoding, the signal statistics may vary significantly from one set of audio signal to another set of audio signal. And even within the same set of audio signal.
If the statistics of the audio signal varies drastically from the statistics of the predefined Huffman table, the encoding of the signal can not be optimally done. And it happens that, to encode the audio signal which has different statistics, the bits consumption by Huffman coding is much more than the bits consumption by fixed length coding.
One possible solution is to include both the Huffman coding and fixed length coding in the encoding, and the encoding method which consumes fewer bits are selected. One flag signal is transmitted to decoder side to indicate which coding method is selected in encoder. This solution is utilized in a newly standardized ITU-T speech codec G.719.
The solution solves the problem for some very extreme sequences in which the Huffman coding consumes more bits than the fixed length coding. But for other input signals which have different statistics from the Huffman table but still select the Huffman coding, it is still not optimal.
In ITU-T standardized speech codec G.719, Huffman coding is used in encoding of the norm factors' quantization indices.
The structure of G.719 is illustrated in Figure 1.
At encoder side, the input signal sampled at 48 kHz is processed through a transient detector (101). Depending on the detection of a transient, a high frequency resolution or a low frequency resolution transform (102) is applied on the input signal frame. The obtained spectral coefficients are grouped into bands of unequal lengths. The norm of each band is estimated (103) and resulting spectral envelope consisting of the norms of all bands is quantized and encoded (104). The coefficients are then normalized by the quantized norms (105). The quantized norms are further adjusted (106) based on adaptive spectral weighting and used as input for bit allocation (107). The normalized spectral coefficients are lattice-vector quantized and encoded (108) based on the allocated bits for each frequency band. The level of the non-coded spectral coefficients is estimated, coded (109) and transmitted to the decoder. Huffman encoding is applied to quantization indices for both the coded spectral coefficients as well as the encoded norms.

At decoder side, the transient flag is first decoded which indicates the frame configuration, i.e., stationary or transient. The spectral envelope is decoded and the same, bit-exact, norm adjustments and bit-allocation algorithms are used at the decoder to recompute the bit-allocation which is essential for decoding quantization indices of the normalized transform coefficients. After de-quantization (112), low frequency non-coded spectral coefficients (allocated zero bits) are regenerated by using a spectral-fill codebook built from the received spectral coefficients (spectral coefficients with non-zero bit allocation) (113). Noise level adjustment index is used to adjust the level of the regenerated coefficients. High frequency non-coded spectral coefficients are regenerated using bandwidth extension. The decoded spectral coefficients and regenerated spectral coefficients are mixed and lead to normalized spectrum. The decoded spectral envelope is applied leading to the decoded full-band spectrum (114). Finally, the inverse transform (115) is applied to recover the time-domain decoded signal. This is performed by applying either the inverse modified discrete cosine transform for stationary modes, or the inverse of the higher temporal resolution transform for transient mode.

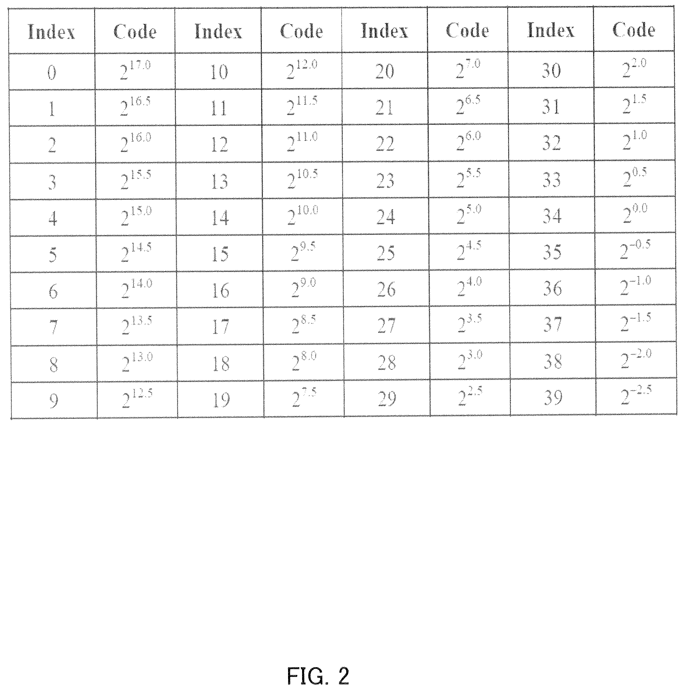

In encoder (104), the norm factors of the spectral sub bands are scalar quantized with a uniform logarithmic scalar quantizer with 40 steps of 3dB. The codebook entries of the logarithmic quantizer are shown in Figure 2. As seen in the codebook, the range of the norm factors is $[2^{-2,5}, 2^{17}]$, and the value decreases as the index increases.

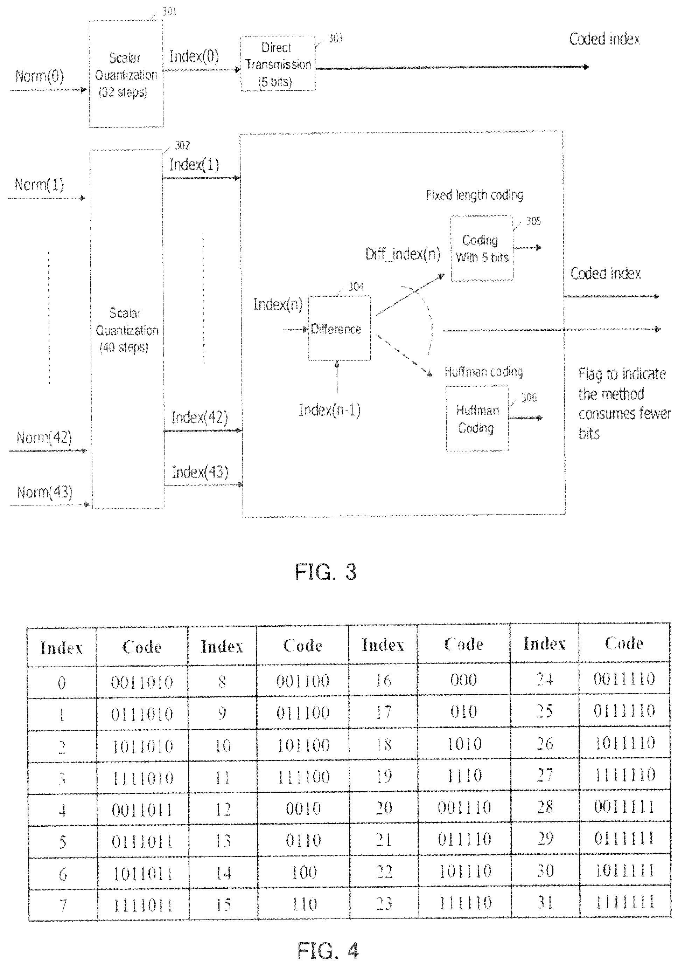

The encoding of quantization indices for norm factors is illustrated in Figure 3. There are in total 44 sub bands and correspondingly, 44 norm factors. For the first sub band, the norm factor is quantized using the first 32 codebook entries (301), while other norm factors are scalar quantized with the 40 codebook entries (302) shown in Figure 2. The quantization index for the first sub band norm factor is directly encoded with 5 bits (303), while the indices for other sub bands are encoded by differential coding. The differential indices are derived using the formula as following (304):

[1]

$$Diff\_index(n) = Index(n) - Index(n-1) + 15 \quad for \quad n \in [1, 43] \quad \ldots \quad (Equation\ 1)$$

And the differential indices are encoded by two possible methods, fixed length coding (305) and Huffman coding (306). The Huffman table for the differential indices is shown in Figure 4. In this table, there are in total 32 entries, from 0 to 31, which caters for possibilities of abrupt energy change between neighboring sub bands.

However, for an audio input signal, there is a physical phenomenon named as auditory masking. Auditory masking occurs when the perception of one sound is affected by the presence of another sound. As example, if there are two signals with similar frequencies existing at the same time: one powerful spike at 1kHz and one lower-level tone at 1.1kHz, the lower-level tone at 1.1kHz will be masked (inaudible) due to existence of the powerful spike at 1kHz.

The sound pressure level needed to make the sound perceptible in the presence of another sound (masker), is defined as masking threshold in audio encoding. The masking threshold depends upon the frequency, the sound pressure level of the masker. If the two sounds have similar frequency, the masking effect is large, and the masking threshold is also large. If the masker has large sound pressure level, it has strong masking effect on the other sound, and the masking threshold is also large.

According to the auditory masking theory above, if one sub band has very large energy, it would have large masking effect on other sub bands, especially on its neighboring sub bands. Then the masking threshold for other sub bands, especially the neighboring sub band, is large.

If the sound component in the neighboring sub band has small quantization errors (less than the masking threshold), the degradation on sound component in this sub band is not able to be perceived by the listeners.

It is not necessary to encode the normal factor with very high resolution for this sub band as long as the quantization errors below the masked threshold.

Solution to Problem

The problem is solved by the subject matter of the independent claim. Advantageous embodiments are subject to the dependent claims.

In this invention, apparatus and methods exploring audio signal properties for generating Huffman tables and for selecting Huffman tables from a set of predefined tables during audio signal encoding are provided.

Briefly, the auditory masking properties are explored to narrow down the range of the differential indices, so that a Huffman table which have fewer code words can be designed and used for encoding. As the Huffman table has fewer code words, it is possible to design the code codes with shorter length (consumes fewer bits). By doing this, the total bits consumption to encode the differential indices can be reduced.

Advantageous Effects of Invention

By adopting Huffman codes which consume fewer bits, the total bits consumption to encode the differential indices can be reduced.

Brief Description of Drawings

Figure 1 illustrates the framework of ITU-T G.719;
Figure 2 shows the codebook for norm factors quantization;
Figure 3 illustrates the process of norm factors quantization and coding;
Figure 4 shows the Huffman table used for norm factors indices encoding;
Figure 5 shows the framework which adopts this invention;
Figures 6A and 6B show examples of predefined Huffman tables;
Figure 7 illustrates the derivation of the masking curve;
Figure 8 illustrates how the range of the differential indices be narrowed down;
Figure 9 shows a flowchart of how the modification of the indices is done;
Figure 10 illustrates how the Huffman tables can be designed;
Figure 11 illustrates the framework of embodiment 2 of this invention;
Figure 12 illustrates the framework of embodiment 3 of this invention;
Figure 13 illustrates the encoder of embodiment 4 of this invention;
Figure 14 illustrates the decoder of embodiment 4 of this invention.

Description of Embodiments

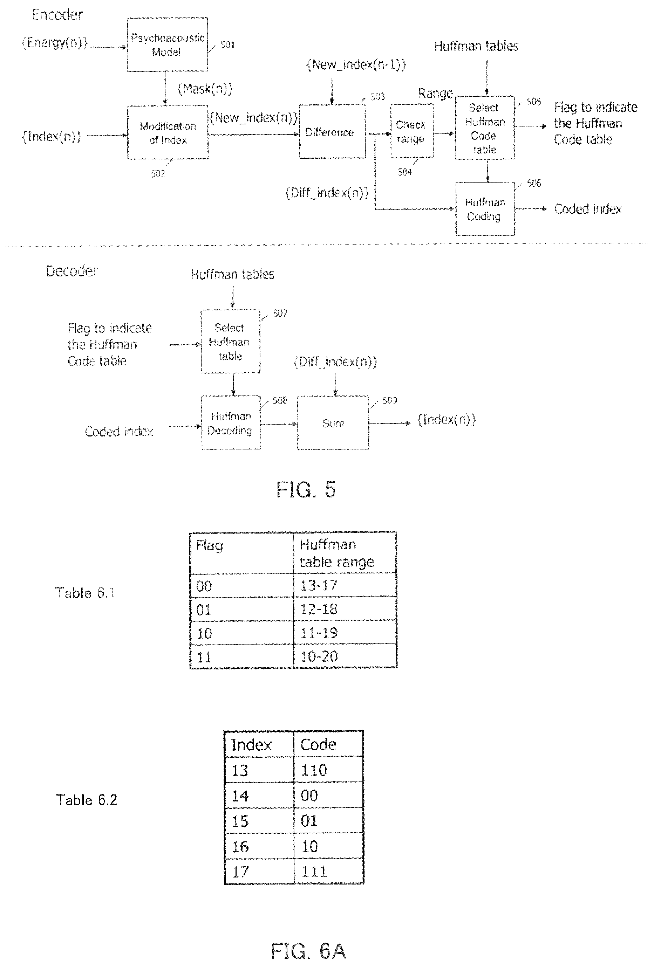

The main principle of the invention is described in this section with the aid of Figure 5 to Figure 12. Illustrations are provided to facilitate explanation.

(Embodiment 1)

Figure 5 illustrates the invented codec, which comprises an encoder and a decoder that apply the invented scheme on Huffman coding.
In the encoder illustrated in Figure 5, the energies of the sub bands are processed by the psychoacoustic modelling (501) to derive the masking threshold Mask(n). According to the derived Mask(n), the quantization indices of the norm factors for the sub bands whose quantization errors are below the masking threshold are modified (502) so that the range of the differential indices can be smaller.
The differential indices for the modified indices are calculated according to the equation below:

[2]

$$Diff\_index(n) = New\_index(n) - New\_index(n-1) + 15$$
$$for \quad n \in [1, 43] \qquad \qquad \dots \quad (Equation\ 2)$$

The range of the differential indices for Huffman coding is identified as shown in the equation below (504).
[3]

$$Range = [Min(Diff\_index(n), Max(Diff\_index(n))] \qquad \dots \quad (Equation\ 3)$$

According to the value of the range, the Huffman table which is designed for the specific range among a set of predefined Huffman table is selected (505) for encoding of the differential indices (506). As example, if among all the differential indices for the input frame, the minimum value is 12, and the maximum value is 18, then the Range = [12,18]. The Huffman table designed for [12,18] are selected as the Huffman table for encoding.
The set of predefined Huffman tables are designed (detail will be explained in later part) and arranged according to the range of the differential indices. The flag signal to indicate the selected Huffman table and the coded indices are transmitted to the decoder side.

Another method for selection of Huffman table is to calculate all the bits consumption using every Huffman table, then select the Huffman table which consumes fewest bits.

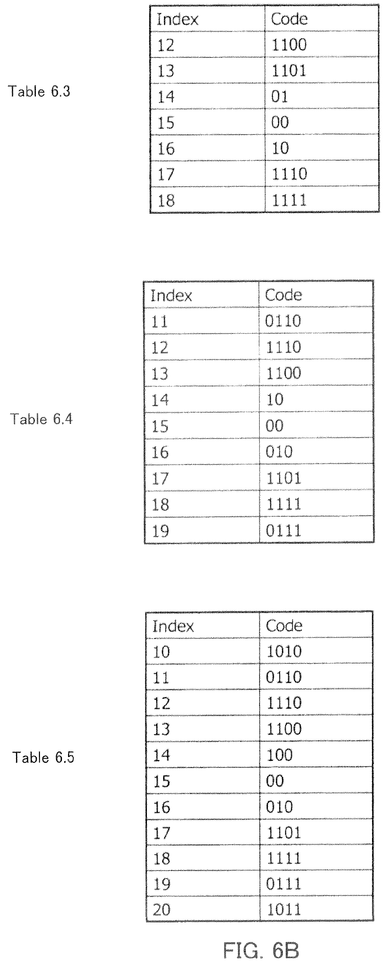

As example, a set of 4 predefined Huffman tables are shown in Figures 6A and 6B. In this example, there are 4 predefined Huffman tables, covered range of [13,17], [12,18],[11,19] and [10,20] correspondingly. Table 6.1 shows the flag signal and corresponding range for Huffman table. Table 6.2 shows the Huffman codes for all the values in the range of [13,17]. Table 6.3 shows the Huffman codes for all the values in the range of [12,18]. Table 6.4 shows the Huffman codes for all the values in the range of [11,19]. Table 6.5 shows the Huffman codes for all the values in the range of [10,20].

Comparing the Huffman code length in Figures 6A and 6B with the original Huffman table shown in Figure 4, it can be seen that the Huffman code length for the same values consumes fewer bits. It explains how the bits are saved.

In the decoder illustrated in Figure 5, according to the flag signal, the corresponding Huffman table is selected (507) for decoding of the differential indices (508). The differential indices are used to reconstruct the norm factors quantization indices according to the equation below:

[4]

$$Diff\_index(n) = Index(n) + Index(n-1) - 15$$
$$for \quad n \in [\,1, 43\,] \qquad \qquad \ldots \text{ (Equation 4)}$$

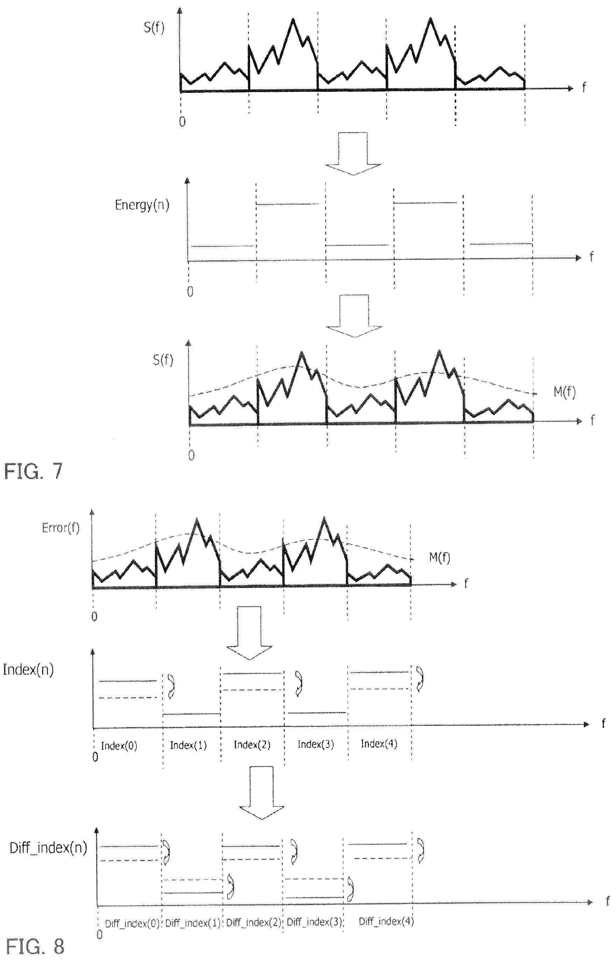

Figure 7 illustrates the derivation of the masking curve of the input signal. Firstly, the energies of the sub bands are calculated, and with these energies and masking curve of the input signal are derived. The masking curve derivation can utilize some prior art existing technologies such as the masking curve derivation method in MPEG AAC codec.

Figure 8 illustrates how the range of the differential indices is narrowed down. Firstly, the comparison is done between the masking threshold and the sub band quantization error energy. For the sub bands whose quantization errors energy are below the masking threshold, their indices are modified to a value which is closer to the neighbouring sub band, but the modification is ensured that the corresponding quantization error energy does not exceed the masking threshold, so that sound quality is not affected. After the modification, the range of the indices can be narrowed down. It is explained as below.

As shown in figure 8, for sub bands 0, 2 and 4, because their quantization error energies are below the masking threshold, their indices are modified to be closer to their neighbouring indices.

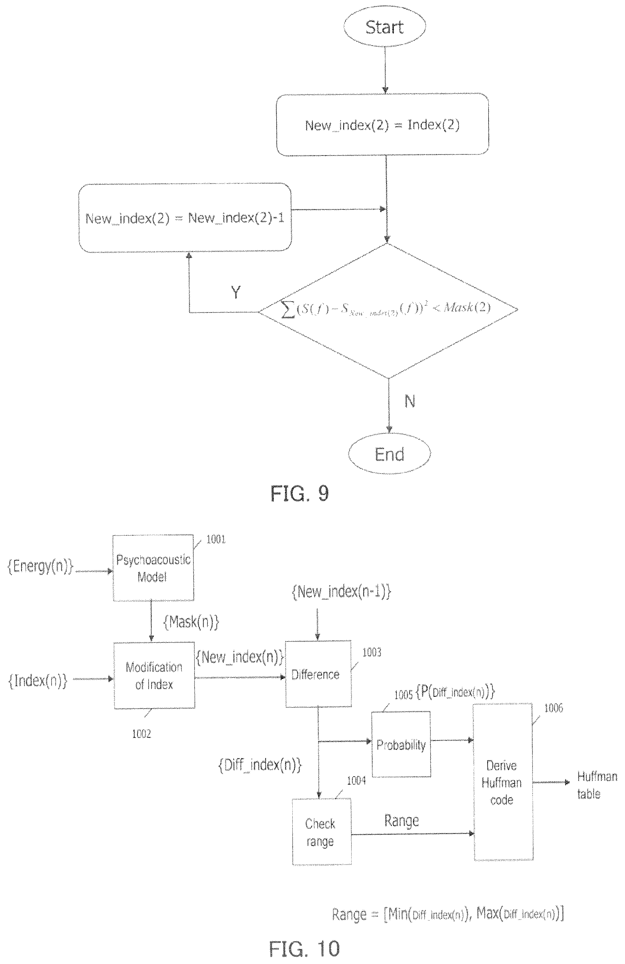

The modification of the indices can be done as below (using sub band 2 as example). As shown in Figure 2, large index is corresponding to smaller energy, and then Index(1) is smaller than Index(2). The modification of Index(2) is actually to decrease its value. It can be done as shown in Figure 9.

For sub bands 1 and 3, because their energies are above the masking threshold, their indices are not changed. Then the differential indices are closer to the centre. Using sub band 1 as example:

[5]

$$Diff\_index(1) = Index(1) - Index(0) + 15 \ for \quad n \in [\,1, 43\,] \qquad \ldots \text{ (Equation 5)}$$

[6]

$$New\_diff\_index(1) = New\_index(1) - New\_index(0) + 15 \qquad \ldots \text{ (Equation 6)}$$
$$for \quad n \in [\,1, 43\,]$$

[7]

$$\because New\_index(1) - New\_index(0) < Index(1) - Index(0)$$
$$\therefore New\_diff\_index(1) - 15 < Diff\_index(1) - 15 \qquad \qquad \ldots \text{ (Equation 7)}$$

In this invention, the design of the Huffman table can be done offline with a large input sequence database. The process is illustrated in Figure 10.

The energies of the sub bands processed by the psychoacoustic modelling (1001) to derive the masked threshold Mask(n). According to the derived Mask(n), the quantization indices of the norm factors for the sub bands whose quantization errors energy are below the masking threshold are modified (1002) so that the range of the differential indices can be smaller.

The differential indices for the modified indices are calculated (1003).

The range of the differential indices for Huffman coding is identified (1004). For each value of range, all the input signal which have the same range will be gathered and the probability distribution of each value of the differential index within the range is calculated.

For each value of range, one Huffman table is designed according to the probability. Some traditional Huffman table design methods can be used here to design the Huffman table.

(Embodiment 2)

In this embodiment, a method which can maintain the bits saving, but to restore the differential indices to a value closer to the original value is introduced.

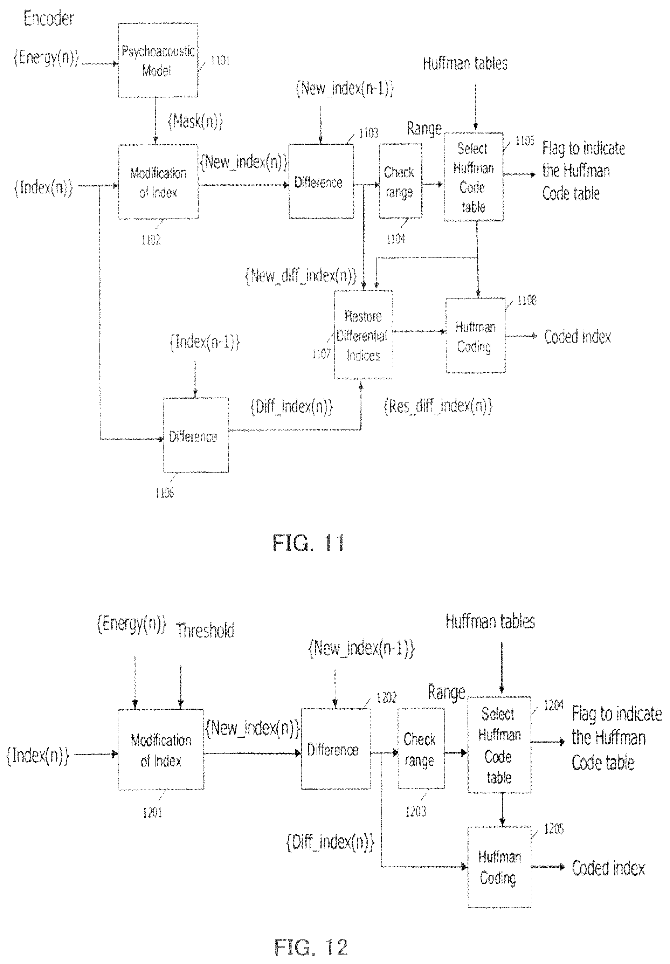

As shown in figure 11, after the Huffman table is selected in 1105, the differential indices are calculated between the original quantization indices. The original differential indices and new differential indices are compared whether they consume same bits in the selected Huffman table.

If they consume same number of bits in the selected Huffman table, the modified differential indices are restored to the original differential indices. If they don't consume same number of bits, the code words in the Huffman table which is closest to the original differential indices and consumes same number of bits are selected as the restored differential indices.

The merits of this embodiment are quantization error of the norm factor can be smaller while the bits consumption is the same as the embodiment 1.

(Embodiment 3)

In this embodiment, a method which avoids using of the psychoacoustic model but only use some energy ratio threshold is introduced.

As shown in figure 12, instead of using the psychoacoustic model to derive the masking threshold. The energies of the sub bands and a predefined energy ratio threshold are used to determine whether to modify the quantization index of the specific sub band (1201). As shown in the equation below, if the energy ratio between current sub band and neighbouring sub band is less than threshold, then current sub band is considered as not so important, then the quantization index of the current sub band can be modified.

[8]

$$Energy(n) / Energy(n-1) \quad < Threshold$$
$$\&\& \quad Energy(n) / Energy(n+1) \quad < Threshold \qquad \ldots \quad (Equation\ 8)$$

The modification of the quantization index can be done as shown in the equation below:

[9]

$$(\frac{NF_{New\_index(n)}}{NF_{Index(n)}})^2 \quad = Min(Energy(n-1), Energy(n+1)) * Threshold / Energy(n)$$

$$\Rightarrow NF_{New\_index(n)} \quad = \sqrt{Min(Energy(n-1), Energy(n+1)) * Threshold / Energy(n)} * NF_{Index(n)}$$

$$\ldots \quad (Equation\ 9)$$

where,

$NF_{New\_index(n)}$ means the decoded norm factor for sub band n using modified quantization index
$NF_{Index(n)}$ means the decoded norm factor for sub band n using the original quantization index
$Energy_{(n-1)}$ means the energy for sub band n -1

*Energy*(*n*) means the energy for sub band n

*Energy*(*n* + 1) means the energy for sub band n + 1

The merit of this embodiment is the very complex and high complexity psychoacoustic modelling can be avoided.

(Embodiment 4)

In this embodiment, a method which narrows down the range of the differential indices while being able to perfectly reconstruct the differential indices is introduced.

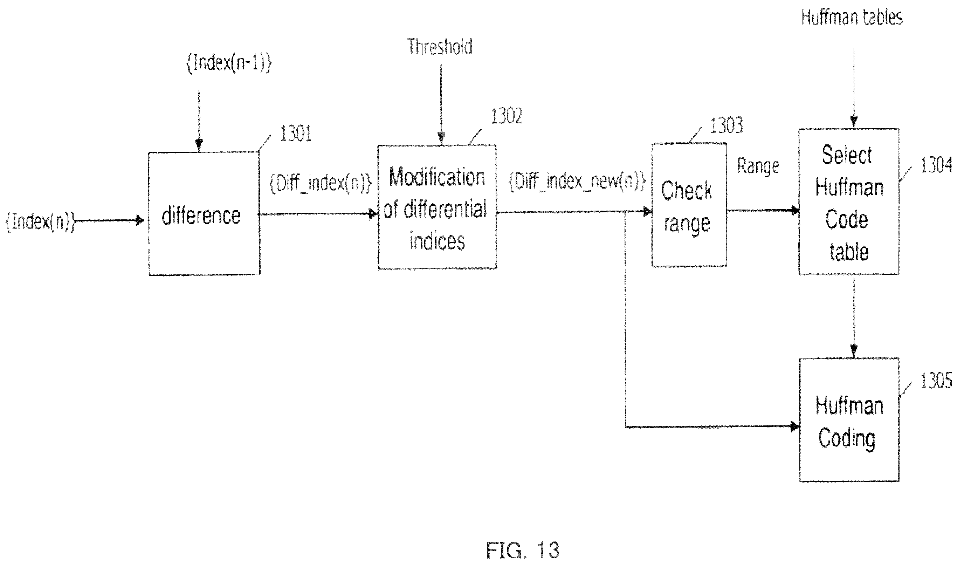

As shown in figure 13, the differential indices are derived from the original quantization indices (1301) according to the equation below:

[10]

$$Diff\_index(\text{n}) = Index(\text{n}) - Index(\text{n} - 1) + 15 \quad \dots \quad (\text{Equation } 10)$$

where,

*Diff_index*(n) means differential index for sub band n

*Index*(n) means the quantization index for sub band n

*Index*(n -1) means the quantization index for sub band n -1

In order to reduce the range of the differential indices, a module is implemented to modify values of some differential indices (1302).

The modification is done according to the value of the differential index for the preceding sub band and a threshold.

One way to modify the differential index (when n ≥ 1) can be done as shown in the equation below, the first differential index would not be modified so as to achieve perfect reconstruction in decoder side:

[11]

$$\begin{aligned}
&\text{if } Diff\_index\,(\text{n} - 1) > (15 + Threshold\,), \\
&\quad Diff\_index\_new\,(\text{n}) = Diff\_index\,(\text{n}) + Diff\_index\,(\text{n} - 1) - (15 + Threshold\,); \\
&\text{else if } Diff\_index\,(\text{n} - 1) < (15 - Threshold\,), \\
&\quad Diff\_index\_new\,(\text{n}) = Diff\_index\,(\text{n}) + Diff\_index\,(\text{n} - 1) - (15 - Threshold\,); \\
&\text{otherwise} \\
&\quad Diff\_index\_new\,(\text{n}) = Diff\_index\,(\text{n}); \qquad\qquad\qquad \dots \quad (\text{Equation } 11)
\end{aligned}$$

where,

n ≥ 1;

*Diff_index* (n) means differential index for sub band n;

*Diff_index* (n -1) means differential index for sub band n -1;

*Diff_index _new*(n) means the new differential index for sub band n;

*Threshold* means the value to examine whether to make the modification of the differential index:

The reason why this modification can reduce the range of the differential indices is explained as following: for audio/speech signal, it is true that the energy fluctuates from one frequency band to another frequency band. However, it is observed that, there is normally no abrupt change in energy from neighboring frequency bands. The energy gradually increases or decreases from one frequency band to another frequency band. The norm factors which represent the energy also gradually changes. The norm factor quantization indices would also gradually change, and then the differential indices would vary in a small range.

The abrupt energy change happens only when some main sound components which have large energy start to show effect in the frequency band or their effect start to diminish. The norm factors which represent the energy also have abrupt change from the preceding frequency band, the norm factor quantization indices would also suddenly increase or decrease by a large value. Then it resulted in a very large or very small differential index.

As an example, assume that there is one main sound component which has large energy in frequency sub band n. While in frequency sub band (n-1) and (n+1), there is no main sound component. Then according to the Huffman table in Figure 2, Index (n) will have very small value, while Index (n-1) and Index (n+1) will have very large value. Then according to Equation (10), Diff_index(n) is very small (less than (15-Threshold)) and Diff_index(n+1) is very large. If the modification in Equation (11) is conducted, then according to Equation (12) below, the upper boundary of the differential indices can be possibly reduced, therefore the range of the differential indices can be narrowed down.

[12]

$$
\begin{aligned}
&\because Diff\_index\_new\,(n-1) < (15 - Threshold)\\
&\therefore Diff\_index(n-1) - (15 - Threshold) < 0\\
&\because Diff\_index\_new\,(n) = Diff\_index(n) + Diff\_index(n-1) - (15 - Threshold);\\
&\therefore Diff\_index\_new\,(n) < Diff\_index(n) \qquad \qquad \ldots \ \text{(Equation 12)}
\end{aligned}
$$

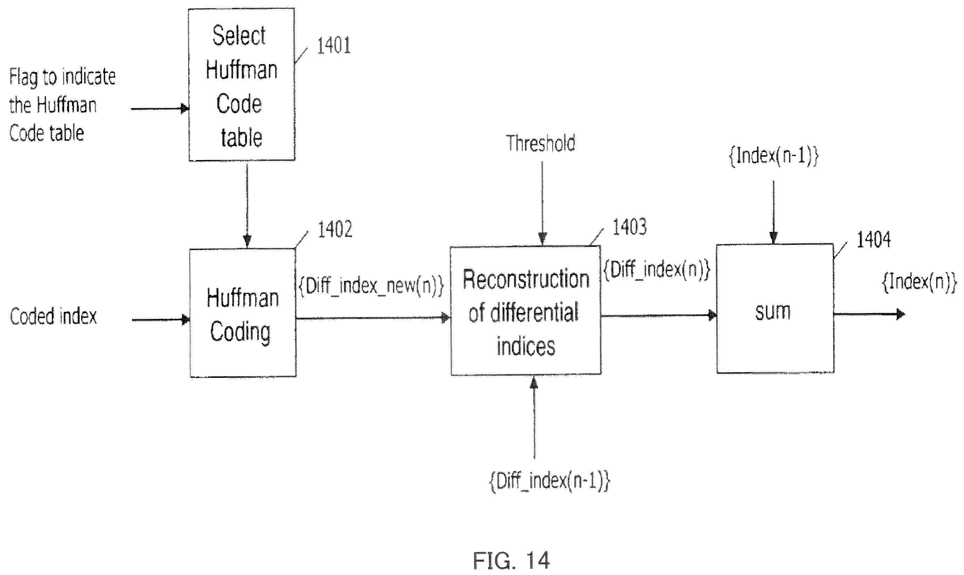

As shown in Figure 14, in decoder side, in order to perfectly reconstruct the differential indices, one module named as 'reconstruction of differential indices' (1403) is implemented. The reconstruction is done according to the value of the differential index for the preceding sub band and a threshold. The threshold in decoder is same as the threshold used in encoder.

The way to reconstruct the differential index(when $n \geq 1$), which is corresponding to the modification in encoder, can be done as shown in the equation below, the first differential index would be directly received as it is not modified at encoder side:

[13]

$$
\begin{aligned}
&\text{if } Diff\_index\,(n-1) > (15 + Threshold),\\
&\quad Diff\_index\,(n) = Diff\_index\_new(n) - Diff\_index\,(n-1) + (15 + Threshold);\\
&\text{else if } Diff\_index\,(n-1) < (15 - Threshold),\\
&\quad Diff\_index\,(n) = Diff\_index\_new(n) - Diff\_index\,(n-1) + (15 - Threshold);\\
&\text{otherwise}\\
&\quad Diff\_index(n) = Diff\_index\_new(n); \qquad \qquad \ldots \ \text{(Equation 13)}
\end{aligned}
$$

where,

$n \geq 1$;

$Diff\_index$(n) means differential index for sub band n;

$Diff\_index$ (n -1) means differential index for sub band n -1;

$Diff\_index\_new$(n) means the new differential index for sub band n:

$Threshold$ means the value to examine whether to reconstruct the differential index:

As shown in the above Equation (11) and Equation (13), whether the modification of a differential index should be done and how much it should be modified is all dependent on the differential index for preceding frequency band. If the differential index for the preceding frequency band can be perfectly reconstructed, then the current differential index can also be perfectly reconstructed.

As shown in the above Equation (11) and Equation (13), the first differential index is not modified at encoder side, it is directly received and can be perfectly reconstructed, then the second differential index can be reconstructed according to the value of the first differential index; then the third differential index, the forth differential index, and so on, by following the same procedure, all the differential indices can be perfectly reconstructed.

The merit of this embodiment is that the range of the differential indices can be reduced, while the differential indices can still be perfectly reconstructed in decoder side. Therefore, the bits efficiency can be improved while retain the bit exactness of the quantization indices.

Further, although cases have been described with the embodiments above where the present invention is configured by hardware, the present invention may be implemented by software in combination with hardware.

Each function block employed in the description of the aforementioned embodiment may typically be implemented as an LSI constituted by an integrated circuit. These may be individual chips or partially or entirely contained on a single chip. "LSI" is adopted here but this may also be referred to as "IC," "system LSI," "super LSI" or "ultra LSI" depending on differing extents of integration.

Further, the method of circuit integration is not limited to LSI's, and implementation using dedicated circuitry or general purpose processors is also possible. After LSI manufacture, utilization of an FPGA (Field Programmable Gate Array) or a reconfigurable processor where connections and settings of circuit cells within an LSI can be reconfigured is also possible.

Further, if integrated circuit technology comes out to replace LSI's as a result of the advancement of semiconductor technology or a derivative other technology, it is naturally also possible to carry out function block integration using this technology. Application of biotechnology is also possible.

Industrial Applicability

The encoding apparatus, decoding apparatus and encoding and decoding methods according to the present invention are applicable to a wireless communication terminal apparatus, base station apparatus in a mobile communication system, tele-conference terminal apparatus, video conference terminal apparatus and voice over internet protocol (VOIP) terminal apparatus.

Reference Notations List

| | |
|------|----------------------------------|
| 101 | Transient detector |
| 102 | Transform |
| 103 | Norm estimation |
| 104 | Norm quantization and coding |
| 105 | Spectrum normalization |
| 106 | Norm adjustment |
| 107 | Bit allocation |
| 108 | lattice quantization and coding |
| 109 | Noise level adjustment |
| 110 | Multiplex |
| 111 | Demultiplex |
| 112 | Lattice decoding |
| 113 | Spectral fill generator |
| 114 | Envelope shaping |
| 115 | Inverse transform |
| 301 | Scalar Quantization (32 steps) |
| 302 | Scalar Quantization (40 steps) |
| 303 | Direct Transmission (5 bits) |
| 304 | Difference |
| 305 | Fixed length coding |
| 306 | Huffman coding |
| 501 | Psychoacoustic model |
| 502 | Modification of index |
| 503 | Difference |
| 504 | Check range |
| 505 | Select Huffman code table |
| 506 | Huffman coding |
| 507 | Select Huffman table |
| 508 | Huffman decoding |
| 509 | Sum |
| 1001 | Psychoacoustic model |
| 1002 | Modification of index |
| 1003 | Difference |
| 1004 | Check range |
| 1005 | Probability |
| 1006 | Derive Huffman code |
| 1101 | Psychoacoustic model |
| 1102 | Modification of index |
| 1103 | Difference |

1104 Check range
1105 Select Huffman code table
1106 Difference
1107 Restore differential indices
1108 Huffman coding
1201 Modification of index
1202 Difference
1203 Check range
1204 Select Huffman code table
1205 Huffman coding
1301 Difference
1302 Modification of differential indices
1303 Check range
1304 Select Huffman code table
1305 Huffman coding
1401 Select Huffman code table
1402 Huffman coding
1403 Reconstruction of differential indices
1404 Sum

**Claims**

1.  An audio/speech encoding apparatus comprising:

 a transformation section configured to transform the time domain input signal to frequency domain signal;
 a band splitting section configured to split the frequency domain signal to a plural of sub bands;
 a norm factor computation section configured to derive norm factors which represent the level of energies for each sub band;
 a quantization section configured to quantize the norm factors and further configured to determine quantization indices;
 a psychoacoustic modelling section (501) configured to derive a masking threshold for each sub band;
 a modification of index section (502) configured to modify the quantization indices, wherein the modification of index section further comprises:

 an energy computation section configured to compute the energies for each sub band, and
 a search section configured to identify the sub bands whose quantization error energy is below the derived masking threshold, and

 the modification of index section is configured to modify the indices of the identified sub bands by decreasing the indices value to be close to their neighboring sub band indices while the quantization error energy for the modified indices is below the derived masking threshold;
 a Huffman table selection section (505) configured to select a Huffman table from among a number of predefined Huffman tables;
 a Huffman coding section (506) configured to encode the indices using the selected Huffman table, wherein the Huffman coding section further comprises:

 a differential index calculation section (503) configured to calculate differential indices between the current sub band and the previous sub band, and

 the Huffman coding section is configured to encode the differential indices; and
 a flag signal transmission section configured to transmit the flag signal to indicate the selected Huffman table.

2.  The audio/speech encoding apparatus of claim 1, wherein said Huffman table selection section (505) further comprises:

 a range computation section (504) configured to compute a range between a minimum value and a maximum value of the differential indices; and

the Huffman table selection section (505) is configured to select a Huffman table from among predefined Huffman tables which is designed for the computed range.

3. The audio/speech encoding apparatus of claim 1, wherein said Huffman table selection section (505) further comprises:

a bits consumption computation section configured to compute bits consumptions required to encode the differential indices for all the predefined Huffman tables; and
the Huffman table selection section is configured to select a Huffman table with which the bit consumption is minimum.

4. The audio/speech encoding apparatus of claim 1, wherein said Huffman coding section further comprises:

an index restore section (1107) configured to compare an original quantization index and the modified quantization index whether they consume same number of bits in the selected Huffman table (1108) and to select an index as a restored index as follows,

(i) if the bit consumption is same, the original quantization index is selected instead of the modified quantization index and
(ii) if the bit consumption is not same, a new index is selected in the Huffman table which is closest to the original index and consumes same number of bits; and

the Huffman coding section (1108) is configured to encode the restored index.

**Patentansprüche**

1. Audio-/Sprachcodierungsvorrichtung, umfassend:

einen Umwandlungsabschnitt, der konfiguriert ist zum Umwandeln eines Zeitdomänen-Eingangssignals zu einem Frequenzdomänensignal,
einen Bandteilungsabschnitt, der konfiguriert ist zum Teilen des Frequenzdomänensignals in eine Vielzahl von Subbändern,
einen Normfaktor-Berechnungsabschnitt, der konfiguriert ist zum Ableiten von Normfaktoren, die den Pegel von Energien für jedes Subband wiedergeben,
einen Quantisierungsabschnitt, der konfiguriert ist zum Quantisieren der Normfaktoren und weiterhin konfiguriert ist zum Bestimmen von Quantisierungsindizes,
einen psychoakustischen Modellierungsabschnitt (501), der konfiguriert ist zum Ableiten eines Maskierungsschwellwerts für jedes Subband,
einen Indexmodifikationsabschnitt (502), der konfiguriert ist zum Modifizieren der Quantisierungsindizes, wobei:

der Indexmodifikationsabschnitt weiterhin umfasst:

einen Energieberechnungsabschnitt, der konfiguriert ist zum Berechnen der Energien für jedes Subband, und
einen Suchabschnitt, der konfiguriert ist zum Identifizieren der Subbänder, deren Quantisierungsfehlerenergie unter dem abgeleiteten Maskierungsschwellwert liegt, und

der Indexmodifikationsabschnitt konfiguriert ist zum Modifizieren der Indizes der identifizierten Subbänder durch das Vermindern des Werts der Indizes, sodass sie den benachbarten Subbandindizes nahe sind, wobei die Quantisierungsfehlerenergie für die modifizierten Indizes unter dem abgeleiteten Maskierungsschwellwert ist,
einen Huffman-Tabellen-Auswahlabschnitt (505), der konfiguriert ist zum Auswählen einer Huffman-Tabelle aus einer Anzahl von vordefinierten Huffman-Tabellen,
einen Huffman-Codierabschnitt (506), der konfiguriert ist zum Codieren der Indizes unter Verwendung der ausgewählten Huffman-Tabelle, wobei:

der Huffman-Codierabschnitt weiterhin umfasst:

einen Differentialindex-Berechnungsabschnitt (503), der konfiguriert ist zum Berechnen von Differentialindizes zwischen dem aktuellen Subband und dem vorausgehenden Subband, und

der Huffman-Codierabschnitt konfiguriert ist zum Codieren der Differentialindizes, und
einen Flag-Signal-Sendeabschnitt, der konfiguriert ist zum Senden des Flag-Signals, um die ausgewählte Huffman-Tabelle anzugeben.

2. Audio-/Sprachcodierungsvorrichtung nach Anspruch 1, wobei der Huffman-Tabellen-Auswahlabschnitt (505) weiterhin umfasst:

einen Bereichsberechnungsabschnitt (504), der konfiguriert ist zum Berechnen eines Bereichs zwischen einem Minimalwert und einem Maximalwert der Differentialindizes,
wobei der Huffman-Tabellen-Auswahlabschnitt (505) konfiguriert ist zum Auswählen einer Huffman-Tabelle, die für den berechneten Bereich vorgesehen ist, aus vordefinierten Huffman-Tabellen.

3. Audio-/Sprachcodiervorrichtung nach Anspruch 1, wobei der Huffman-Tabellen-Auswahlabschnitt (505) weiterhin umfasst:

einen Bitverbrauch-Berechnungsabschnitt, der konfiguriert ist zum Berechnen von Bitverbräuchen, die für das Codieren der Differentialindizes für alle die vordefinierten Huffman-Tabellen erforderlich sind,
wobei der Huffman-Tabellen-Auswahlabschnitt konfiguriert ist zum Auswählen einer Huffman-Tabelle, mit welcher der Bitverbrauch minimal ist.

4. Audio-/Sprachcodiervorrichtung nach Anspruch 1, wobei der Huffman-Codierabschnitt weiterhin umfasst:

einen Index-Wiederherstellungsabschnitt (1107), der konfiguriert ist zum Vergleichen eines ursprünglichen Quantisierungsindex mit dem modifizierten Quantisierungsindex in Bezug darauf, ob diese die gleiche Anzahl von Bits in der ausgewählten Huffman-Tabelle verbrauchen (1108), und zum Auswählen eines Index als eines wiederhergestellten Index wie folgt:

(i) wenn der Bitverbrauch gleich ist, wird der ursprüngliche Quantisierungsindex anstatt des modifizierten Quantisierungsindex ausgewählt, und
(ii) wenn der Bitverbrauch nicht gleich ist, wird ein neuer Index in der Huffman-Tabelle, der dem ursprünglichen Index am nahsten ist und die gleiche Anzahl von Bits verbraucht, ausgewählt,

wobei der Huffman-Codierabschnitt (1108) konfiguriert ist zum Codieren des wiederhergestellten Index.

**Revendications**

1. Appareil de codage audio/vocal comprenant :

une section de transformation configurée pour transformer le signal d'entrée de domaine temporel en signal de domaine fréquentiel ;
une section de division de bande configurée pour diviser le signal de domaine fréquentiel en une pluralité de sous-bandes ;
une section de calcul de facteur normal configurée pour dériver des facteurs normaux qui représentent les niveaux d'énergie de chaque sous-bande ;
une section de quantification configurée pour quantifier les facteurs normaux et configurée en outre pour déterminer des indices de quantification ;
une section de modélisation psychoacoustique (501) configurée pour dériver un seuil de masquage pour chaque sous-bande ;
une section de modification d'indice (502) configurée pour modifier les indices de quantification, dans lequel la section de modification d'indice comprend en outre :

une section de calcul d'énergie configurée pour calculer les énergies pour chaque sous-bande, et
une section de recherche configurée pour identifier les sous-bandes dont l'énergie d'erreur de quantification est inférieure au seuil de masquage dérivé, et

la section de modification d'indice est configurée pour modifier les indices des sous-bandes identifiées en diminuant la valeur des indices pour qu'ils soient proches des indices de leurs sous-bandes voisines alors que l'énergie d'erreur de quantification pour les indices modifiés est inférieure au seuil de masquage dérivé ;
une section de sélection de table de Huffman (505) configurée pour sélectionner une table de Huffman parmi un nombre de tables de Huffman prédéfini ;
une section de codage de Huffman (506) configurée pour coder les indices à l'aide de la table de Huffman sélectionnée, dans lequel
la section de codage de Huffman comprend en outre :

une section de calcul d'indice différentiel (503) configurée pour calculer des indices différentiels entre la sous-bande actuelle et la sous-bande précédente, et

la section de codage de Huffman est configurée pour coder les indices différentiels ; et
une section de transmission de signal de drapeau est configurée pour transmettre le signal de drapeau pour indiquer la table de Huffman sélectionnée.

2. Appareil de codage audio/vocal selon la revendication 1, dans lequel ladite section de sélection de table de Huffman (505) comprend en outre :

une section de calcul de plage (504) configurée pour calculer une plage entre une valeur minimale et une valeur maximale des indices différentiels ; et
la section de sélection de table de Huffman (505) est configurée pour sélectionner une table de Huffman qui est conçue pour la plage calculée parmi des tables de Huffman prédéfinies.

3. Appareil de codage audio/vocal selon la revendication 1, dans lequel ladite section de sélection de table de Huffman (505) comprend en outre :

une section de calcul de consommation de bits configurée pour calculer des consommations de bits requises pour coder les indices différentiels pour toutes les tables de Huffman prédéfinies ; et
la section de sélection de table de Huffman est configurée pour sélectionner une table de Huffman avec laquelle la consommation de bits est minimale.

4. Appareil de codage audio/vocal selon la revendication 1, dans lequel ladite section de codage de Huffman comprend en outre :

une section de restauration d'indice (1107) configurée pour comparer un indice de quantification original et l'indice de quantification modifié pour déterminer s'ils consomment ou non le même nombre de bits dans la table de Huffman sélectionnée (1108) et pour sélectionner un indice comme indice restauré comme suit :

(i) si la consommation de bits est la même, l'indice de quantification original est sélectionné au lieu de l'indice de quantification modifié, et
(ii) si la consommation de bits n'est pas la même, un nouvel indice plus proche de l'indice original et consommant le même nombre de bits est sélectionné dans la table de Huffman ; et

la section de codage de Huffman (1108) est configurée pour coder l'indice restauré.

Encoder

FIG. 1

| Index | Code | Index | Code | Index | Code | Index | Code |
|-------|------|-------|------|-------|------|-------|------|
| 0 | $2^{17.0}$ | 10 | $2^{12.0}$ | 20 | $2^{7.0}$ | 30 | $2^{2.0}$ |
| 1 | $2^{16.5}$ | 11 | $2^{11.5}$ | 21 | $2^{6.5}$ | 31 | $2^{1.5}$ |
| 2 | $2^{16.0}$ | 12 | $2^{11.0}$ | 22 | $2^{6.0}$ | 32 | $2^{1.0}$ |
| 3 | $2^{15.5}$ | 13 | $2^{10.5}$ | 23 | $2^{5.5}$ | 33 | $2^{0.5}$ |
| 4 | $2^{15.0}$ | 14 | $2^{10.0}$ | 24 | $2^{5.0}$ | 34 | $2^{0.0}$ |
| 5 | $2^{14.5}$ | 15 | $2^{9.5}$ | 25 | $2^{4.5}$ | 35 | $2^{-0.5}$ |
| 6 | $2^{14.0}$ | 16 | $2^{9.0}$ | 26 | $2^{4.0}$ | 36 | $2^{-1.0}$ |
| 7 | $2^{13.5}$ | 17 | $2^{8.5}$ | 27 | $2^{3.5}$ | 37 | $2^{-1.5}$ |
| 8 | $2^{13.0}$ | 18 | $2^{8.0}$ | 28 | $2^{3.0}$ | 38 | $2^{-2.0}$ |
| 9 | $2^{12.5}$ | 19 | $2^{7.5}$ | 29 | $2^{2.5}$ | 39 | $2^{-2.5}$ |

FIG. 2

FIG. 3

| Index | Code | Index | Code | Index | Code | Index | Code |
|-------|---------|-------|--------|-------|--------|-------|---------|
| 0 | 0011010 | 8 | 001100 | 16 | 000 | 24 | 0011110 |
| 1 | 0111010 | 9 | 011100 | 17 | 010 | 25 | 0111110 |
| 2 | 1011010 | 10 | 101100 | 18 | 1010 | 26 | 1011110 |
| 3 | 1111010 | 11 | 111100 | 19 | 1110 | 27 | 1111110 |
| 4 | 0011011 | 12 | 0010 | 20 | 001110 | 28 | 0011111 |
| 5 | 0111011 | 13 | 0110 | 21 | 011110 | 29 | 0111111 |
| 6 | 1011011 | 14 | 100 | 22 | 101110 | 30 | 1011111 |
| 7 | 1111011 | 15 | 110 | 23 | 111110 | 31 | 1111111 |

FIG. 4

Encoder

FIG. 5

Table 6.1

| Flag | Huffman table range |
|------|---------------------|
| 00 | 13-17 |
| 01 | 12-18 |
| 10 | 11-19 |
| 11 | 10-20 |

Table 6.2

| Index | Code |
|-------|------|
| 13 | 110 |
| 14 | 00 |
| 15 | 01 |
| 16 | 10 |
| 17 | 111 |

FIG. 6A

Table 6.3

| Index | Code |
|-------|------|
| 12 | 1100 |
| 13 | 1101 |
| 14 | 01 |
| 15 | 00 |
| 16 | 10 |
| 17 | 1110 |
| 18 | 1111 |

Table 6.4

| Index | Code |
|-------|------|
| 11 | 0110 |
| 12 | 1110 |
| 13 | 1100 |
| 14 | 10 |
| 15 | 00 |
| 16 | 010 |
| 17 | 1101 |
| 18 | 1111 |
| 19 | 0111 |

Table 6.5

| Index | Code |
|-------|------|
| 10 | 1010 |
| 11 | 0110 |
| 12 | 1110 |
| 13 | 1100 |
| 14 | 100 |
| 15 | 00 |
| 16 | 010 |
| 17 | 1101 |
| 18 | 1111 |
| 19 | 0111 |
| 20 | 1011 |

FIG. 6B

FIG. 7

FIG. 8

Start

New_index(2) = Index(2)

New_index(2) = New_index(2)-1

Y

$$\sum (S(f) - S_{New\_index(2)}(f))^2 < Mask(2)$$

N

End

FIG. 9

{Energy(n)} → Psychoacoustic Model  1001

{Mask(n)}

{Index(n)} → Modification of Index  1002

{New_index(n)} → Difference  1003

{New_index(n-1)}

{Diff_index(n)}

1005 {P(Diff_index(n))}

Probability

1006

Derive Huffman code → Huffman table

1004

Check range

Range

Range = [Min(Diff_index(n)), Max(Diff_index(n))]

FIG. 10

Encoder

{Energy(n)} → Psychoacoustic Model ⟋1101

{Mask(n)}

{New_index(n-1)}

Huffman tables

{Index(n)} → Modification of Index 1102 → {New_index(n)} → Difference ⟋1103 → Range → Check range ⟋1104 → Select Huffman Code table ⟋1105 → Flag to indicate the Huffman Code table

{New_diff_index(n)}

Restore Differential Indices ⟋1107 → Huffman Coding ⟋1108 → Coded index

{Index(n-1)}

Difference ⟋1106 → {Diff_index(n)} → {Res_diff_index(n)}

**FIG. 11**

{Energy(n)} Threshold

{New_index(n-1)}

Huffman tables

{Index(n)} → Modification of Index 1201 → {New_index(n)} → Difference ⟋1202 → Range → Check range ⟋1203 → Select Huffman Code table ⟋1204 → Flag to indicate the Huffman Code table

{Diff_index(n)} → Huffman Coding ⟋1205 → Coded index

**FIG. 12**

FIG. 13

FIG. 14

EP 2 701 144 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002268693 A

- US 2006074693 A1